(19) Europäisches Patentamt
European Patent Office
Office européen des brevets

(11) **EP 1 982 209 B1**

(12) **FASCICULE DE BREVET EUROPEEN**

(45) Date de publication et mention
de la délivrance du brevet:
**26.05.2010 Bulletin 2010/21**

(21) Numéro de dépôt: **07726217.8**

(22) Date de dépôt: **22.01.2007**

(51) Int Cl.:
***G01S 7/02*** *(2006.01)*    ***G01R 23/02*** *(2006.01)*

(86) Numéro de dépôt international:
**PCT/EP2007/050608**

(87) Numéro de publication internationale:
**WO 2007/090730 (16.08.2007 Gazette 2007/33)**

(54) **RECEPTEUR NUMERIQUE LARGE BANDE DE MESURE DE FREQUENCE**

FREQUENZ ZUR MESSUNG DES BREITBANDDIGITALEMPFÄNGERS

FREQUENCY MEASURING BROADBAND DIGITAL RECEIVER

(84) Etats contractants désignés:
**ES GB IT**

(30) Priorité: **10.02.2006 FR 0601205**

(43) Date de publication de la demande:
**22.10.2008 Bulletin 2008/43**

(73) Titulaire: **THALES**
**92200 Neuilly sur Seine (FR)**

(72) Inventeurs:
• **BRIAND, Thierry**
**F-78290 Croissy Sur Seine (FR)**

• **GUERBEUR, Gilles**
**F-92370 Chaville (FR)**

(74) Mandataire: **Lucas, Laurent Jacques**
**Marks & Clerk France**
**Conseils en Propriété Industrielle**
**Immeuble " Visium "**
**22, avenue Aristide Briand**
**94117 Arcueil Cedex (FR)**

(56) Documents cités:
**WO-A-2004/097450    FR-A- 2 695 730**
**US-B1- 6 448 921    US-B1- 6 690 315**

## Description

L'invention concerne plus précisément un récepteur très large bande destiné à la mesure instantanée de la fréquence de signaux reçus (ou interceptés) par le récepteur notamment dans le domaine des fréquences radar.

Les récepteurs destinés à la détection de signaux radioélectriques de type radar (ou télécommunications) sont notamment utilisés dans le domaine de la guerre électronique. Ces types de récepteurs comportent des fonctions de mesure de fréquence instantanée et du niveau du signal reçu.

Le problème technique qui se pose pour des tels récepteurs est de mesurer la fréquence des signaux interceptés avec :

- une bonne sensibilité ; la puissance de bruit intrinsèque à un récepteur large bande instantanée impose de travailler avec un rapport signal à bruit très faible, voir négatif, pour obtenir la sensibilité requise,
- une durée de mesure, et donc d'intégration, faible ; le but étant de caractériser des émissions radar dont la durée d'impulsion peut être très courte,
- des mesures des signaux interceptées à une cadence élevée ; le but est d'associer les mesures de fréquence et de niveau pour caractériser les signaux interceptés avec une bonne résolution temporelle,
- un récepteur de mesure à faible coût et de faible volume ; une amélioration importante dans ce domaine permet, par exemple dans des systèmes de détection, de multiplier le nombre de récepteur par système et donc d'améliorer les performances du système sans grever ni le prix ni le volume du système.

Les récepteurs de l'état de l'art fonctionnant à des très hautes fréquences comportent généralement des étages d'entrée analogiques suivis d'étages de traitement numérique du signal.

Un principe de fonctionnement d'un récepteur de l'état de l'art permettant une mesure instantanée de la fréquence du signal reçu désigné par « fréquencemètre à échantillonnage spatial » est basé sur la création d'un régime d'ondes stationnaires, à partir du signal reçu, dans une ligne de propagation et de mesurer la position des noeuds et des ventres répartis le long de cette ligne de propagation, la périodicité des noeuds et des ventres donne une mesure grossière de la fréquence du signal reçu.

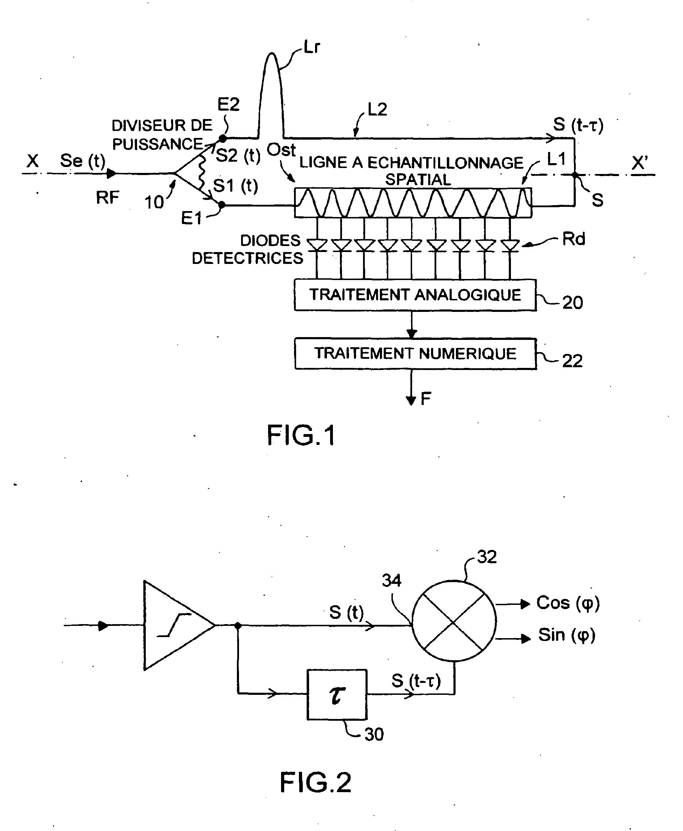

La figure 1 représente un principe de récepteur de l'état de l'art montrant une façon pratique d'obtenir ce régime d'ondes stationnaires.

Un signal reçu se(t), après amplification analogique, est réparti par un répartiteur de puissance 10 vers deux sorties du répartiteur. Chaque signal s1(t) et s2(t) aux deux sorties du répartiteur 10 est appliqué, l'un s1(t) à une entrée E1 d'une ligne analogique L1 de propagation et l'autre s2(t) à une entrée E2 d'une autre ligne analogique L2 de propagation, les deux lignes analogiques étant orientées selon un axe XX'. L'autre ligne analogique L2 comporte en série une ligne à retard Lr. Les deux lignes L1 et L2 sont connectées par leur sortie S.

Le signal s1(t) se propage sur la ligne L1 dans le sens croissant des x selon cet axe XX'. Un autre signal signal s2(t-τ) obtenu à partir du signal s2(t) retardé de τ par la ligne à retard Lr est injecté par la ligne L2 à l'autre extrémité S de la ligne L1 et se propage sur la ligne L1 dans le sens des x décroissants. Il en résulte un régime d'ondes stationnaires Ost le long de la ligne de propagation L1 produisant des noeuds et des ventres de tension dont la périodicité fournit une mesure grossière de la fréquence F du signal reçu par le récepteur.

Les positions des noeuds et des ventres sont détectées par une rangée Rd de diodes détectrices disposées le long des de la ligne L1 dont les signaux de sortie font l'objet d'un traitement de signal analogique 20 puis numérique 22 fournissant cette mesure de fréquence F grossière de pulsation ω.

La position des noeuds et des ventres s'exprime par l'expression

$$g(x) = k.A.^2 \left[ 1 + \cos\left[ \frac{2\omega x}{Vo} \right] + \varphi \right] \qquad \text{avec } f = \frac{\varphi}{2\pi.\tau}$$

La position des noeuds et des ventres (donc le terme φ) donne une mesure fine de la fréquence, mais ambiguë.

g(x) est échantillonné le long de la ligne de propagation L1. Une transformée de Fourier discrète permet d'extraire la mesure grossière de fréquence et la mesure fine ambiguë. Les compromis de précision nécessaires à la levée de l'ambiguïté doivent être réalisés.

Dans un autre principe de fonctionnement du récepteur de l'état de l'art dit « auto-corrélateur à ligne à retard », l'idée est de mesurer directement la différence de phase φ induite par une ligne à retard 30 de retard τ.

La figure 2 représente cet autre principe d'un récepteur de l'état de l'art pour la mesure de fréquences du signal reçu.

La mesure de déphasage entre le signal reçu s(t) et le signal reçu retardé de τ s(t-τ) est effectuée par un mélangeur de type BLU 32 (bande latérale unique) recevant par une entrée de mélange 34 le signal reçu s(t) et par une autre entrée de mélange le signal s(t-τ) retardé de τ. On en déduit la fréquence du signal $F_{mesurée}$ :

$$Fmesurée = \frac{\varphi}{2\pi.\tau}$$

La phase est mesurée à $2\pi$ près. Pour obtenir une mesure non ambiguë dans un domaine de fréquence donnée, la longueur de ligne (retard $\tau$) est limitée. En revanche, pour une erreur de phase donnée, plus $\tau$ est grand, plus la mesure de fréquence est précise. Pour obtenir la précision de fréquence requise sans ambiguïté, il est nécessaire d'utiliser simultanément plusieurs lignes à retard. La ligne la plus longue donne la précision, la, où les autres lignes, permettent de lever les ambiguïtés.

La demande de brevet FR 2 695 730 de la société AEROMETRICS INC décrit un procédé et un dispositif pour déterminer la fréquence d'un signal électronique comportant des étapes de division du signal électronique en une pluralité de N signaux simultanés puis échantillonage des N signaux et optention de la fréquence du signal reçu à partir des N mesures de fréquence des dits N signaux.

Les récepteurs de l'état de l'art mettant en ouvre ces solutions pour mesurer la fréquence du signal reçu comportent des inconvénients notamment :

- un volume et un coût important ;
- utilisent des fonctions analogiques donc soumises à des dérives telles que :

  • variations des retards en fonction de la température,
  • imperfections des mesures de niveau (solution échantillonnage spatial) ;
  • imperfections des mesures de déphasage (solution auto-correlateur à ligne à retard).

Par conséquent, il est nécessaire, dans ces solutions de l'état de l'art, de recourir à des réglages et des étalonnages pour compenser ces dérives analogiques et améliorer la précision et la fidélité des mesures de fréquence. Ceci contribue, en outre, à augmenter le coût de ces solutions et limiter la précision

Les solutions de l'état de l'art ne sont pas adaptées à une extraction de la modulation de phase du signal. En effet un saut de phase sur le signal incident n'est visible que pendant un transitoire de durée correspondant au temps de propagation dans la ligne à retard. Cette durée étant très faible, l'exploitation de l'information est difficile.

Pour pallier les inconvénients des récepteurs de mesure de fréquence de l'état de l'art, l'invention propose un récepteur hyperfréquences configuré pour la mesure de la fréquence F du signal hyperfréquences reçu par le récepteur, dans une bande de fréquences dont la fréquence maximale est Fmax, le récepteur comportant N étages numériques E1, E2,...Ek,...EN de mesure de fréquence fournissant N mesures de fréquence ambiguës Fm1, Fm2, ...Fmk,....FmN du signal reçu, le signal reçu étant échantillonné, dans chaque étage numérique, à une respective fréquence d'échantillonnage Fe1, Fe2,...Fek,...FeN, le récepteur comportant en outre un dispositif de levée d'ambiguïté (40) recevant les N mesures de fréquence et fournissant la fréquence F du signal reçu, chaque étage Ek numérique de mesure de fréquence comportant :

- un convertisseur analogique numérique un bit (50) attaqué directement par le signal hyperfréquence reçu par le récepteur, chaque convertisseur fournissant un signal numérique réel à une fréquence d'échantillonnage Fek,
- des moyens de calcul pour effectuer une transformée de Fourier discrète à partir des échantillons en sortie du convertisseur un bit,
- au moins un détecteur de maximum de raie (60, 62) de la transformée de Fourier discrète fournie par les moyens de calcul,

**caractérisé en ce que** chaque fréquencemètre Ek (k prenant une valeur entière entre 1 et N) fournit Nptk points d'échantillonnage à un dispositif TFD (52) de calcul de la transformée de Fourrier discrète à partir des points d'échantillonnage, le dispositif de calcul TFD (52) effectuant la transformée de Fourier discrète sur Nptk points en continu avec un recouvrement temporel de 50%, le dispositif fournissant à une première sortie (54) une première transformée de fourrier discrète TFDi-1 des Nptk points d'échantillonnage pendant une première période de temps d'échantillonnage Tei-1 et à une deuxième sortie (56) une deuxième transformée de fourrier discrète TFDi des Nptk points d'échantillonnage pendant une deuxième période de temps d'échantillonnage Tei se recouvrant avec la première sur 50% du temps d'échantillonnage des Nptk points (i étant l'indice temporel des transformées de Fourier discrètes ou TFD).

Dans une réalisation préférentielle du récepteur, les respectives fréquences d'échantillonnage Fe1, Fe2,...Fek,...FeN des convertisseurs analogique numérique un bit des étages du récepteur sont inférieures à la fréquence maximale Fmax de la bande du récepteur.

Un principal objectif de cette invention est de réduire le coût et le volume du récepteur.

Un autre objectif est de pouvoir obtenir au prix d'une complexité plus grande des performances supérieures à celle de récepteurs de l'état de l'art.

Le principe du récepteur selon l'invention est basé sur une numérisation du signal reçu dès l'entrée du récepteur dans la très large bande de réception du récepteur. Cette numérisation comprend la quantification (discrétisation de l'amplitude du signal) et l'échantillonnage (discrétisation en temporel).

Dans le récepteur selon l'invention, la fréquence est la seule information traitée, la quantification en amplitude du signal reçu s'effectue sur un seul bit, ce qui est équivalent à une quantification en phase sur deux états.

En pratique la numérisation du signal reçu est effectuée par une bascule D dont la bande passante couvre au moins la bande hyperfréquence Fmax, ce qui est actuellement possible avec les technologies disponibles sur le marché.

Un autre aspect important de l'invention réside dans le fait que l'échantillonnage numérique du signal reçu s'effectue à une fréquence bien inférieure à la fréquence maximale pouvant être reçue par le récepteur.

En traitement numérique du signal, la règle de base est le respect du théorème de Shannon. Il serait possible d'échantillonner à une fréquence compatible avec le théorème de Shannon mais le coût et l'encombrement du récepteur seraient plus importants. En effet, une fréquence d'échantillonnage très élevée entraîne une complexité de l'interface entre la bascule D d'échantillonnage et le circuit numérique, ainsi qu'un volume très important du traitement numérique.

Une des idées de base de la présente invention d'utiliser une fréquence d'échantillonnage du signal reçu par le récepteur nettement inférieure à celle nécessaire au respect du théorème de Shannon. Il en découle des ambiguïtés dues au repliement de spectre étant donné qu'à une fréquence mesurée Fmk (ou fournie par un étage Ek de mesure de fréquence du récepteur) correspond à plusieurs fréquences F1, F2,... Fp possibles à l'entrée du récepteur.

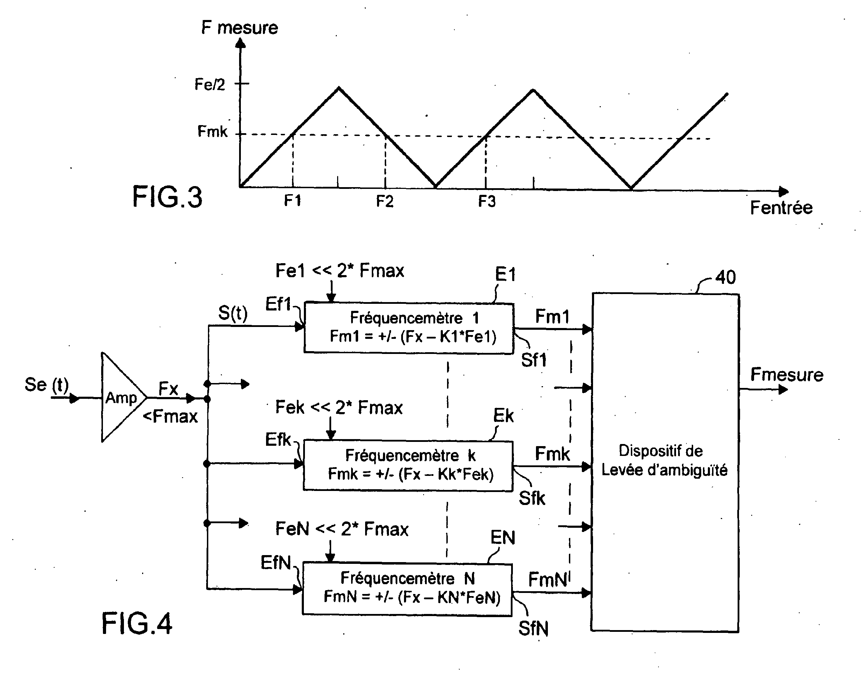

La figure 3 illustre ce problème d'ambiguïté des différentes fréquences possibles F1, F2,... Fp en entrée du récepteur pour une fréquence mesurée Fmk.

L'invention sera mieux comprise à l'aide d'exemples de réalisation de récepteurs de mesure de fréquence selon l'invention en référence aux figures annexées dans les quelles :

- la figure 1, déjà décrite, représente un principe d'un récepteur de l'état de l'art pour la mesure de fréquences du signal reçu ;
- la figure 2, déjà décrite, représente un autre principe d'un récepteur de l'état de l'art pour la mesure de fréquences du signal reçu ;
- la figure 3, déjà décrite, illustre le problème d'ambiguïté des différentes fréquences possibles en entrée du récepteur ;
- la figure 4 représente un synoptique d'un récepteur de mesure de fréquence, selon l'invention ;
- la figure 5 montre un synoptique d'un fréquencemètre numérique Ek du récepteur ;
- la figure 6 montre une représentation dans le temps des transformées de Fourier TFDi-1 et TDFi du fréquencemètre Ek ;

- la figure 7, représente les racines unité $W_N^{kn}$ .

La figure 4 représente un synoptique d'un récepteur de mesure de fréquence, selon l'invention, du signal reçu.

Le récepteur comporte :

- un amplificateur Amp large bande pour adapter le signal se(t) reçu par l'antenne aux étages numérique de mesure de fréquence ;
- N étages numériques E1, E2,... Ek,...EN de mesure de la fréquence (ou fréquencemètre) du signal reçu s(t) en sortie de l'amplificateur Amp, chaque étage fournissant respectivement, à partir du signal reçu s(t) appliqué à une entrée Efk du fréquencemètre, une fréquence de mesure Fmk (avec k indice de la voie de mesure de fréquence, ou du fréquencemètre, prenant les valeurs entières de 1 à N), chaque étage effectuant un échantillonnage du signal s(t) appliqué son entrée Efk à une respective fréquence d'échantillonnage Fe1, Fe2,...Fek,...FeN ;
- un dispositif 40 pour lever les ambiguïtés sur les fréquences mesurées Fmk par les différents étages numériques de mesure de fréquences E1, E2,...Ek,...EN fournissant une valeur vraie Fmesure de la fréquence du signal reçu par le récepteur.

Chacun des fréquencemètres E1, E2,...Ek,...EN fournit à une respective sortie Sfk une mesure de fréquence Fmk exprimée par :

pour le fréquencemètre E1,. $Fm1 = +/-(Fx - K1*Fe1)$

pour le fréquencemètre Ek, $Fmk = +/-(Fx - Kk*Fek)$

pour le fréquencemètre EN, $FmN = +/-(Fx - KN*FeN)$

Le système apparemment plus complexe du fait de l'utilisation de plusieurs fréquencemètres en parallèle, au lieu d'un seul, plus un dispositif de levée de l'ambiguïté de fréquence est d'une réalisation plus simple.

En première approximation, si l'on considère que le volume de traitement est proportionnel au produit fréquence d'échantillonnage (Fek) par le nombre des points du traitement Nptk, et si l'on maintien le temps d'intégration Ti constant, Ti = Npts/Fek, on obtient un volume de traitement qui augmente avec le carré de la fréquence d'échantillonnage.

Dans un exemple de réalisation du récepteur selon l'invention, la fréquence d'échantillonnage de chaque fréquencemètre peut être 10 à 20 fois inférieure à celle nécessaire au respect du théorème de Shannon pour l'échantillonnage à la fréquence maximum Fmax. Dans cette configuration selon l'invention, la réalisation d'une voie de mesure de fréquence Ek ambiguë nécessitera 100 à 400 fois moins de ressource logique. Il suffit des quelques voies (E1, E2,...Ek,...EN) de mesure en parallèle et une levée d'ambiguïté pour obtenir une mesure de fréquence non ambiguë.

En contre partie, la sensibilité du récepteur augmente avec la fréquence d'échantillonnage Fek. En effet la puissance de bruit hyperfréquence se replie en totalité dans la bande de fréquence comprise entre 0 et Fek/2 et la bande de bruit est en 1/Ti=constante. Donc, la puissance de bruit au niveau de la mesure est en 2/(Ti.Fek). Par exemple une multiplication par 2 de la fréquence d'échantillonnage Fek entraîne un gain de sensibilité de 3dB.

Dans le récepteur selon l'invention, un compromis est réalisé permettant la même sensibilité que les solutions de l'état de l'art avec un seul FPGA soit « Field Programmable Gate Array » en langue anglaise, de technologie récente (90nm). L'évolution constante de la technologie FPGA permet une évolution des performances du récepteur de mesure de fréquence selon l'invention à coût constant.

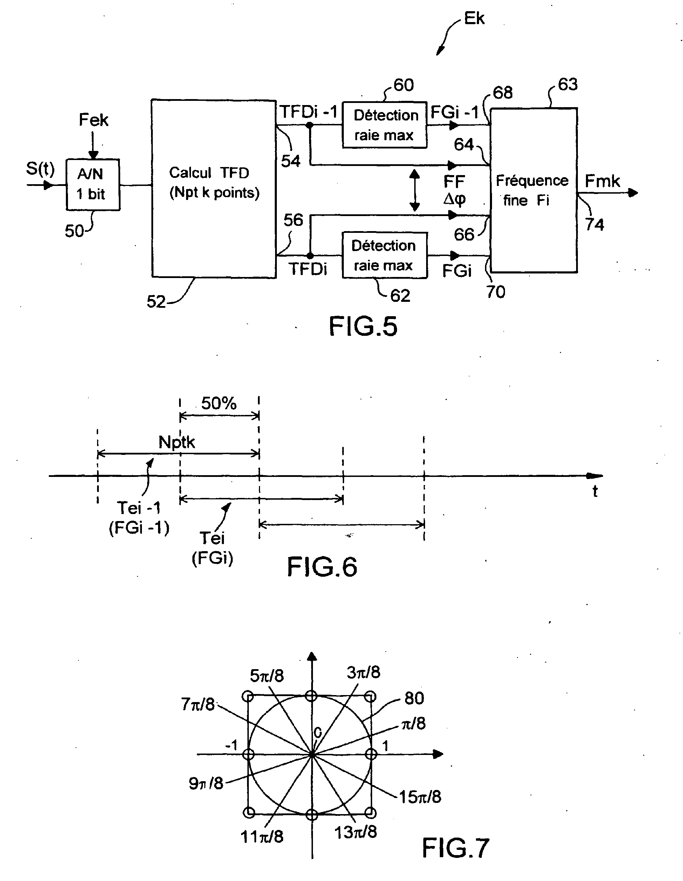

La figure 5 montre un synoptique d'un fréquencemètre numérique Ek (d'indice k) du récepteur de mesure de fréquences selon l'invention.

Chaque fréquencemètre Ek comporte un convertisseur analogique numérique 1 bit 50 fournissant Nptk points d'échantillonnage à un dispositif 52 de calcul de la transformée de Fourier discrète (TFD) à partir des points d'échantillonnage.

Le dispositif de calcul de la TFD effectue la transformée de Fourier discrète sur Nptk points en continu avec un recouvrement temporel de 50%, le dispositif fournissant à une première sortie 54 une première transformée de fourrier discrète TFDi-1 des Nptk points d'échantillonnage pendant une première période de temps d'échantillonnage Tei-1 et à une deuxième sortie 56 une deuxième transformée de fourrier discrète TFDi des Nptk points d'échantillonnage pendant une deuxième période de temps d'échantillonnage Tei se recouvrant avec la première sur 50% du temps d'échantillonnage des Nptk points (i étant l'indice temporel des transformées de Fourier discrètes, ou TFD).

La figure 6 montre une représentation dans le temps t des transformées de Fourier TFDi-1 et TDFi pendant des périodes i-1 et i du fréquencemètre se recouvrant sur 50% de leur temps.

Chaque sortie 54, 56 du dispositif de calcul TFD attaque un respectif détecteur de crête 60, 62 pour détecter la raie maximum de chacune des transformée de Fourier discrètes TFDi-1 et TDFi, chaque détecteur de crête fournissant une respective mesure de fréquences grossières FGi-1 et FGi dont la résolution est Fek/Nptk. Les mesures étant émises avec une récurrence de Nptk/(2.Fek).

La précision obtenue à ce stade est directement inverse du temps d'intégration Ti, celle-ci étant insuffisante par rapport à la précision requise, un deuxième traitement est ajouté. La suite du traitement utilise le résultat de deux transformée de Fourier discrètes, d'indice temporel i-1 et i pour fournir une fréquence Fi d'indice i dite fréquence fine Fi.

A cet effet le fréquencemètre Ek de rang k comporte un dispositif de mesure 63 de la fréquence Fmk recevant, d'une part, par deux entrées 64 et 66 les deux résultats des deux transformées de Fourier discrètes TFDi-1 et TFDi (d'indices temporels i-1 et i), pour le calcul d'une fréquence Fi dite fine mais présentant une ambiguïté et, d'autre part, par deux autres entrées 68, 70, les respectives mesures de fréquences grossières FGi-1 et FGi en sortie des respectifs détecteurs de crête 60, 62 pour lever l'ambiguïté sur la fréquence fine Fi et fournir à une sortie 74 du dispositif de mesure de fréquence 63 la fréquence de mesure Fmk du fréquencemètre de rang k.

Les deux transformées de Fourier discrètes en sortie du dispositif de calculs TFD 52 portent sur des supports d'intégration décalés d'un retard

$\tau$= Nptk/(2.Fek), elles présentent donc une différence de phase φ telle que :

$$\varphi = 2.\pi.F.\tau$$

Cette différence de phase φ fournit la mesure de fréquence fine Fi qui est ambiguë et dont l'ambiguïté est levée par la mesure de fréquence grossière FGi-1 et FGi.

En résumé, en sortie de chaque fréquencemètre Ek, on dispose d'une fréquence dite grossière, la fréquence Fmk est obtenue par un dispositif d'affinage en fréquence qui exploite la différence de phase entre 2 transformées de Fourier consécutives avec recouvrement temporel).

Dans le récepteur de mesure de fréquences, selon l'invention, les fréquences d'échantillonnage Fek sont différentes sur chaque voie (ou chaque fréquencemètre). Dans une première variante du récepteur les calculs des voies 1, 2,..k,...N sont synchronisées sur une même fréquence dès l'entrée du récepteur.

Dans une autre variante du récepteur selon l'invention, la synchronisation des calculs est effectuée en sortie du dispositif de calcul 52 de la TFD pour cela, il faut respecter la relation :

$$\frac{Nptk}{Fek} = Cte \quad ,$$

Cte étant une constante
cette relation doit être respectée pour que les intégrations sur chaque voie portent sur la même tranche temporelle sans glissement.

Sachant que les fréquences d'échantillonnage Fek doivent être proches, la contrainte :

$$\frac{Nptk}{Fek} = Cte$$

conduit à réaliser des transformées de Fourier discrètes sur des nombres des points non en $2^n$. Une solution est de compléter les échantillons temporels par des zéros pour atteindre la puissance de 2 supérieure. Ceci permet d'utiliser un algorithme de transformée de Fourier rapide (ou FFT en langue anglaise) classique.

Il est également possible des rechercher des valeurs de Nptk qui se décompose en facteurs premiers pas trop élevés. On réalise alors une factorisation du calcul de la transformée de Fourier rapide (FFT en langue anglaise) en radix premiers correspondants.

Dans le récepteur selon l'invention, le calcul de la TFD peut être effectué sur un nombre quelconque de points d'échantillonnage (y compris un nombre premier) avec un volume logique inférieur aux solutions précédentes. Dans cette réalisation l'expression de la TFD est :

$$\left[X_N(k)\right] = \sum_{n=0}^{N-1}\left[x(n).W_N^{kn}\right] \qquad \text{avec } .W_N^{kn} = e^{-j2\pi\left(\frac{nk}{N}\right)}$$

l'idée est de remplacer les multiplications :

$$\left[x(n).W_N^{kn}\right]$$

par une opération logique élémentaire. Pour cela, on remplace les racines de l'unité $W_N^{kn}$ qui se déplace sur un cercle unité 80 par les points les plus proches parmi les points indiqués sur un carré de racines l'unité $W_N^{kn}$ tel que représente à la figure 7.

Le carré de la figure 7 est centré sur deux axes perpendiculaires X et Y. Les points du carré sont données par toutes les valeurs pouvant être prises entre -1, 0, 1 sur les deux axes X et Y.

Sachant que le signal temporel noté ici $x(n)$ est lui-même codé sur un seul bit, il ne reste plus que l'addition comme volume logique pour chaque raie spectrale.

Le récepteur comporte le dispositif 40 pour lever les ambiguïtés sur les fréquences mesurées Fm1, Fm2,..Fmk,...FmN par les différents étages de mesure E1, E2,...Ek,...EN fournissant une valeur vraie Fmesure de la fréquence du signal reçu par le récepteur.

Pour une mesure ambiguë sur une voie de mesure de fréquence il y a plusieurs fréquences F1, F2, F3, ....Fp possibles en entrée du récepteur (voir figure 3). Le nombre de possibilités est fonction du taux de sous-échantillonnage par rapport au critère de Shannon.

Pour lever les ambiguïtés sur les fréquences mesurées par les fréquencemètres, le dispositif de levée d'ambiguïté 40 du récepteur selon l'invention recherche les candidats ou les fréquences possibles F1, F2, F3,...Fp en entrée du récepteur qui présentent un écart entre voies Ek de mesure inférieur à un seuil de décision Sd (voir figure 3).

A fort rapport signal sur bruit et avec un choix judicieux des Fek, trois voies de mesure (ou fréquencemètres) sont suffisantes pour lever les ambiguïtés.

. A cet effet le dispositif de levée d'ambiguïté 40 calcule :

- Pour chaque voie Ek (ou récepteur Ek), toutes les fréquences possibles (F1k, F2k, F3k,....Fpk) à partir de la fréquence Fmk (tel que représentées à la figure 3) en se limitant au domaine de fréquence à traiter.
- Puis une voie Er, parmi toutes les voies E1, E2,...Er,.. Ek,...Ex,..Ey,... EN du récepteur, est prise en référence, et pour chaque fréquence possible (F1r, F2r, F3r,....Fpr) de cette voie de référence Er, puis le dispositif de levée d'ambiguïté 40 effectue :

  - la recherche sur deux autres voies Ex, Ey du récepteur, de la fréquence possible (F1x, F2x, F3x,....Fpx) de la voie Ex et, de la fréquence possible (F1y, F2y, F3y,....Fpy) de la voie Ey les plus proches, de chacune des fréquences (F1r, F2r, F3r,....Fpr) de la voie de référence Er, puis on effectue :
  - un calcul des différents écarts entre les fréquences les plus proches des voies Ex, Ey par rapport aux fréquences (F1r, F2r, F3r,....Fpr) de la voie de référence Er ,
  - un test des écarts par rapport au seuil de décision Sd,

- Si l'on trouve un cas de cohérence, déterminé par des écarts inférieurs au seuil Sd, on considère l'ambiguïté levée. Pour améliorer l'écart type de l'erreur de mesure il est possible de calculer la moyenne entre les 3 fréquences possibles retenues (une par voie)
- Si les écarts sont supérieurs au seuil de décision, on considère qu'il n'y a pas cohérence et on rejette cette mesure.

Le but est de fournir que des mesures bonnes (ou vraies) de la fréquence du signal reçu par le récepteur. La levée de l'ambiguïté sera réalisée par la mise en place des critères de rejet de mesures de fréquences notamment en cas de rapport signal à bruit trop faible ou en cas de signaux perturbateurs.

Dans un premier niveau de rejet des mesures de fréquences, un premier critère de rejet est mis en place au niveau des fréquencemètres du récepteur : la cohérence entre les deux fréquences grossières consécutives FGi-1 et FGi des fréquencemètres (voir figure 5) est examinée, si l'écart est supérieur à une raie (un écart d'une raie correspond à la résolution spectrale en sortie de la TFD), la mesure est rejetée.

Il peut rester des cas de mesure fausse non rejetée tels que :

- cas des crêtes de bruit qui tombent sur une même raie, à + ou - une raie, sur deux TDF consécutives ;
- cas d'un signal perturbateur de plus faible puissance, si le signal à mesurer est proche d'un multiple de Fe/2.

Dans un deuxième niveau de rejet des mesures, pour améliorer la robustesse de la mesure, une quatrième voie E4 est ajouté aux trois autres voies du récepteur E1, E2, E3, (N=4), un l’algorithme de rejet prend en compte le fait qu'une voie puisse être fausse. Le principe est de ne pas privilégier une voie plus qu'une autre. Chaque voie a la même importance. C'est pourquoi on teste la cohérence entre les voies dans les quatre cas de figure suivants.

- cas 1 : en enlevant la voie E1 et en utilisant les voies E2, E3 et E4
- cas 2 : en enlevant la voie E2 et en utilisant les voies E1 ,E3 et E4
- cas 3 : en enlevant la voie E3 et en utilisant les voies E1, E2 et E4
- cas 4 : en enlevant la voie E4 et en utilisant les voies E1, E2 et E3

Dans chacun des cas ci-dessus, la voie de référence utilisée pour calculer les écarts peut être l'une quelconque des 3 voies utilisées, mais ne peut pas être la voie supprimée. Pour explorer les 4 cas ci-dessus, ceci conduit à calculer les écarts dans 5 configurations qui peuvent être par exemple :

- Ecarts 1.4 : calcul des écarts de la voie E1 par rapport à la voie E4 en référence
- Ecarts 2.4 : calcul des écarts de la voie E2 par rapport à la voie E4 en référence
- Ecarts 3.4 : calcul des écarts de la voie E2 par rapport à la voie E4 en référence
- Ecarts 1.3 : calcul des écarts de la voie E1 par rapport à la voie E3 en référence

- Ecarts 2.3 : calcul des écarts de la voie E2 par rapport à la voie E3 en référence

Dans cet exemple les 4 cas sont obtenus de la façon suivante :

- Cas 1 (sans la voie E1) : Ecarts 2.4 et Ecarts 3.4
- Cas 2 (sans la voie E2) : Ecarts 1.4 et Ecarts 3.4
- Cas 3 (sans la voie E3) : Ecarts 1.4 et Ecarts 2.4
- Cas 4 (sans la voie E4) : Ecarts 1.3 et Ecarts 2.3

On compare ensuite les résultats obtenus :
On examine d'abord s'il existe une cohérence dans tous les 4 cas. Si oui cela signifie que les quatre voies sont correctes. Pour améliorer l'écart type de l'erreur de mesure finale, il est possible de calculer la moyenne entre les 4 fréquences (une par cas)
Sinon, on examine s'il existe une cohérence dans un seul cas. Si oui cela signifie qu'une voie est fausse, la fréquence retenue est celle issue de ce cas. Sinon, c'est à dire s'il y a cohérence dans 3 cas, 2 cas ou aucun cas, on rejette la mesure
Dans le cas ou une seule voie est fausse, l'algorithme résiste et l'on a 100% de mesures valides.
Dans le cas où 2 voies ou plus sont fausses, généralement l'algorithme ne trouve pas de cohérence et la mesure est rejetée. Il reste des cas possibles d'erreurs, de probabilité extrêmement faible, si des mesures fausses font apparaître une cohérence au mauvais endroit.
Dans un système de mesure de fréquence d'un signal reçu comportant plusieurs récepteurs selon l'invention, le système fournissant en outre un niveau du signal reçu, un troisième niveau de rejet des fréquences mesurées peut être mis en place. Les mesures de niveau et les fréquences fournies par les différents récepteurs du système sont regroupées et corrélées pour détecter la fréquence du signal reçu. Ces mesures sont fournies à la même cadence et sont synchronisées.
A ce niveau ont effectue :

- le rejet de toutes les fréquences si le niveau reçu est sous un seuil de détection.
- le rejet d'une fréquence si elle s'éloigne d'un nuage de points cohérents pendant une impulsion de signal reçu.

Le but est d'intégrer ces informations pour élaborer un descripteur d'impulsion qui comprend entre autres :

- un seul niveau ;
- une seule fréquence plus éventuellement les informations de modulation dans l'impulsion.

Une des caractéristiques importantes du récepteur de mesure de fréquence selon l'invention est qu'il comporte une voie de plus que le nombre des voies nécessaires à la levée d'ambiguïté sur les fréquences et que l'algorithme utilisé pour cette levée d'ambiguïté prenne en compte le fait qu'une voie puisse donner des fréquences fausses.
La réalisation décrite du récepteur de mesure de fréquence selon l'invention a pour but principal de mesurer la fréquence du signal le plus puissant présent dans le signal reçu par le récepteur. Malgré le codage sur un bit, le principe du récepteur proposé a le potentiel pour détecter la présence et mesurer la fréquence d'un deuxième signal présent simultanément. Pour cela les fréquencemètres élémentaires peuvent fournir plusieurs détections (dans la réalisation décrite on ne fournit que la raie la plus forte), et la levée d'ambiguïté peut être complexifiée pour extraire deux fréquences.

## Revendications

**1.** Récepteur hyperfréquences configuré pour la mesure de la fréquence F du signal hyperfréquences reçu par le récepteur, dans une bande de fréquences dont la fréquence maximale est Fmax, le récepteur comportant N étages numériques E1, E2,...Ek,...EN de mesure de fréquence fournissant N mesures de fréquence ambiguës Fm1, Fm2, ...Fmk,....FmN du signal reçu, le signal reçu étant échantillonné, dans chaque étage numérique, à une respective fréquence d'échantillonnage Fe1, Fe2,...Fek,...FeN, le récepteur comportant en outre un dispositif de levée d'ambiguïté (40) recevant les N mesures de fréquence et fournissant la fréquence F du signal reçu, chaque étage Ek numérique de mesure de fréquence comportant :

- un convertisseur analogique numérique un bit (50) attaqué directement par le signal hyperfréquence reçu par le récepteur, chaque convertisseur fournissant un signal numérique réel à une fréquence d'échantillonnage Fek,
- des moyens de calcul pour effectuer une transformée de Fourier discrète à partir des échantillons en sortie du convertisseur un bit,
- au moins un détecteur de maximum de raie (60, 62) de la transformée de Fourier discrète fournie par les moyens de calcul,

**caractérisé en ce que** chaque fréquencemètre Ek (k prenant une valeur entière entre 1 et N) fournit Nptk points d'échantillonnage à un dispositif TFD (52) de calcul de la transformée de Fourrier discrète à partir des points d'échantillonnage, le dispositif de calcul TFD (52) effectuant la transformée de Fourier discrète sur Nptk points en continu avec un recouvrement temporel de 50%, le dispositif fournissant à une première sortie (54) une première transformée de fourrier discrète TFDi-1 des Nptk points d'échantillonnage pendant une première période de temps d'échantillonnage Tei-1 et à une deuxième sortie (56) une deuxième transformée de fourrier discrète TFDi des Nptk points d'échantillonnage pendant une deuxième période de temps d'échantillonnage Tei se recouvrant avec la première sur 50% du temps d'échantillonnage des Nptk points (i étant l'indice temporel des transformées de Fourier discrètes ou TFD).

2. Récepteur hyperfréquences selon la revendication 1, **caractérisé en ce que** les respectives fréquences d'échantillonnage Fe1, Fe2,...Fek,...FeN des convertisseurs analogique numérique un bit des étages du récepteur sont inférieures à la fréquence maximale Fmax de la bande du récepteur.

3. Récepteur hyperfréquences selon l'une des revendications 1 ou 2, **caractérisé en ce que** la fréquence étant la seule information traitée, la quantification en amplitude du signal reçu s'effectue sur un seul bit, ce qui est équivalent à une quantification en phase sur deux états.

4. Récepteur hyperfréquences selon l'une des revendications 1 à 3, **caractérisé en ce que** la numérisation du signal est effectuée par une bascule D dont la bande passante couvre au moins la bande hyperfréquence Fmax.

5. Récepteur hyperfréquences selon l'une des revendications 1 à 4, **caractérisé en ce qu'**il comporte :

- un amplificateur Amp large bande pour adapter le signal se(t) reçu par l'antenne aux étages numérique de mesure de fréquence ;
- N étages numériques E1, E2,...Ek,...EN de mesure de la fréquence (ou fréquencemètre) du signal reçu s(t) en sortie de l'amplificateur Amp, chaque étage fournissant respectivement, à partir du signal reçu s(t) appliqué à une entrée Efk du fréquencemètre, une fréquence de mesure Fmk (avec k indice de la voie de mesure de fréquence, ou du fréquencemètre, prenant les valeurs entières de 1 à N), chaque étage effectuant un échantillonnage du signal s(t) appliqué son entrée Efk à une respective fréquence d'échantillonnage Fe1, Fe2,...Fek,...FeN ;
- un dispositif (40) pour lever les ambiguïtés sur les fréquences mesurées Fmk par les différents étages numériques de mesure de fréquence E1, E2,...Ek,...EN fournissant une valeur vraie (Fmesure) de la fréquence du signal reçu par le récepteur.

6. Récepteur hyperfréquences selon la revendication 5, **caractérisé en ce que** chacun des fréquencemètres E1, E2,...Ek,...EN fournissent, à une respective sortie Sfk, une mesure de fréquence Fmk exprimée par :

pour le fréquencemètre E1, $Fm1 = +/-(Fx - K1 * Fe1)$

pour le fréquencemètre Ek, $Fmk = +/-(Fx - Kk * Fek)$

pour le fréquencemètre EN , $FmN = +/-(Fx - KN * FeN)$

7. Récepteur hyperfréquences selon l'une des revendications 1 à 6, **caractérisé en ce que** la fréquence d'échantillonnage Fe1, Fe2,...Fek,...FeN de chaque fréquencemètre est nettement inférieure à celle nécessaire au respect du théorème de Shannon pour l'échantillonnage à la fréquence maximum Fmax.

8. Récepteur hyperfréquences selon l'une des revendications 1 à 7, **caractérisé en ce que** chaque sortie (54, 56) du dispositif de calcul TFD attaque un respectif détecteur de crête (60, 62) pour détecter la raie maximum de chacune des transformée de Fourier discrètes TFDi-1 et TDFi, chaque détecteur de crête fournissant une respective mesure de fréquence grossière FGi-1 et FGi dont la résolution est Fek/Nptk, les mesures étant émises avec une récurrence de Nptk/(2.Fek).

9. Récepteur hyperfréquences selon la revendication 8, **caractérisé en ce que** chaque fréquencemètre Ek de rang k comporte un dispositif de mesure (63) de la fréquence Fmk recevant, d'une part, par deux entrées (64, 66) les deux résultats des deux transformées de Fourier discrètes TFDi-1 et TFDi (d'indices temporels i-1 et i), pour le calcul d'une fréquence Fi dite fine mais présentant une ambiguïté et, d'autre part, par deux autres entrées (68, 70), les respectives mesures de fréquences grossières FGi-1 et FGi en sortie des respectifs détecteurs de crête (60, 62) pour lever l'ambiguïté sur la fréquence fine Fi et fournir à une sortie (74) du dispositif de mesure de fréquence (63) la fréquence de mesure Fmk du fréquencemètre de rang k.

10. Récepteur hyperfréquences selon l'une des revendications 7 à 9, **caractérisé en ce que** les deux transformées de Fourier discrètes en sortie du dispositif de calculs TFD (52) portent sur des supports d'intégration décalés d'un retard τ
avec

$$\tau = Nptk/(2.Fek),$$

présentant donc une différence de phase φ telle que :

$$\varphi = 2\pi.F.\tau$$

cette différence de phase φ fournissant une mesure de fréquence Fi dite fine qui est ambiguë et dont l'ambiguïté est levée par la mesure de fréquence grossière FGi-1 et FGi.

11. Récepteur hyperfréquences selon l'une des revendications 1 à 10, **caractérisé en ce** les calculs des voies 1, 2,..k,...N sont synchronisées sur une même fréquence dès l'entrée du récepteur.

12. Récepteur hyperfréquences selon l'une des revendications 1 à 10, **caractérisé en ce que** la synchronisation des calculs est effectuée en sortie du dispositif de calcul (52) de la TFD pour cela, il faut respecter la relation :

$$\frac{Nptk}{Fek} = Cte \quad ,$$

Cte étant une constante

13. Récepteur hyperfréquences selon la revendication 1, **caractérisé en ce que** le calcul de la TFD est effectué sur un nombre quelconque de points d'échantillonnage y compris un nombre premier, l'expression de la TFD est :

$$[X_N(k)] = \sum_{n=0}^{N-1}[x(n).W_N^{kn}] \qquad \text{avec } .W_N^{kn} = e^{-j2\pi\left(\frac{nk}{N}\right)}$$

les multiplications :

$$[x(n).W_N^{kn}]$$

étant remplacées par une opération logique élémentaire.

14. Récepteur hyperfréquences selon la revendication 13, **caractérisé en ce que** les racines de l'unité $W_N^{kn}$ qui se déplace sur un cercle unité sont remplacées par les points les plus proches parmi les points indiqués sur un carré de racines l'unité $W_N^{kn}$.

**15.** Procédé pour lever les ambiguïtés sur les fréquences mesurées par les fréquencemètres du récepteur selon l'une des revendications 1 à 12, **caractérisé en ce qu'**il consiste à rechercher les fréquences possibles F1, F2, F3,...Fp qui présentent un écart entre voies inférieur à un seuil de décision Sd.

**16.** Procédé pour lever les ambiguïtés selon la revendication 15, **caractérisé en ce qu'**il comporte les étapes suivantes:

• Pour chaque voie Ek (ou récepteur Ek), calcul de toutes les fréquences possibles (F1k, F2k, F3k,...Fpk.) à partir de la fréquence Fmk en se limitant au domaine de fréquences à traiter,
• Puis une voie Er, parmi toutes les voies E1, E2,...Er,.. Ek,...Ex,..Ey,... EN du récepteur, est prise en référence, et pour chaque fréquence possible (F1r, F2r, F3r,....Fpr) de cette voie de référence Er, on effectue :

- la recherche sur deux autres voies Ex, Ey du récepteur, de la fréquence possible (F1x, F2x, F3x,....Fpx) de la voie Ex et, de la fréquence possible (F1y, F2y, F3y,....Fpy) de la voie Ey les plus proches, de chacune des fréquences (F1r, F2r, F3r,....Fpr) de la voie de référence Er, puis on effectue :
- un calcul des différents écarts entre les fréquences les plus proches des voies Ex, Ey par rapport aux fréquences (F1r, F2r, F3r,....Fpr) de la voie de référence Er ,
- un test des écarts par rapport au seuil de décision Sd,

• Si l'on trouve un cas de cohérence, déterminé par des écarts inférieurs au seuil Sd, on considère l'ambiguïté levée,
• Si les écarts sont supérieurs au seuil de décision, on considère qu'il n'y a pas cohérence et on rejette cette mesure.

**17.** Procédé pour lever les ambiguïtés selon la revendication 16, **caractérisé en ce que** pour améliorer l'écart type de l'erreur de mesure il est possible de calculer la moyenne entre les 3 fréquences possibles retenues (une par voie).

**18.** Récepteur hyperfréquences selon les revendications 15 à 17, **caractérisé en ce qu'**il est configuré pour mettre en place des critères de rejet de mesures de fréquences.

**19.** Récepteur hyperfréquences selon la revendication 18, **caractérisé en ce que** chaque sortie (54, 56) du dispositif de calcul TFD attaquant un respectif détecteur de crête (60, 62) pour détecter la raie maximum de chacune des transformée de Fourier discrètes TFDi-1 et TDFi, chaque détecteur de crête fournissant une respective mesure de fréquence grossière FGi-1 et FGi dont la résolution est Fek/Nptk, les mesures étant émises avec une récurrence de Nptk/(2.Fek), la cohérence entre les deux fréquences grossières consécutives FGi-1 et FGi des fréquencemètres est examinée, si l'écart est supérieur à une raie, un écart d'une raie correspondant à la résolution spectrale en sortie de la TFD, la mesure est rejetée.

**20.** Récepteur hyperfréquences selon l'une des revendications 18 ou 19, **caractérisé en ce que**, dans un deuxième niveau de rejet des mesures, le récepteur comportant quatre voies de mesure de fréquences E1, E2, E3 et E4 (N=4), un algorithme de rejet prend en compte le fait qu'une voie de mesure puisse être fausse et **en ce qu'**on teste la cohérence entre les voies dans les quatre cas de figure suivants.

- cas 1 : en enlevant la voie E1 et en utilisant les voies E2, E3 et E4,
- cas 2 : en enlevant la voie E2 et en utilisant les voies E1, E3 et E4,
- cas 3 : en enlevant la voie E3 et en utilisant les voies E1, E2 et E4,
- cas 4 : en enlevant la voie E4 et en utilisant les voies E1, E2 et E3,

dans chacun des cas ci-dessus, la voie de référence utilisée pour calculer les écarts étant l'une quelconque des 3 voies utilisées, mais ne pouvant pas être la voie supprimée.

**21.** Récepteur hyperfréquences selon la revendication 20, **caractérisé en ce qu'**il est configuré pour explorer les quatre cas de figure, par calcul des écarts dans les 5 configurations suivantes :

• Ecarts 1.4 : calcul des écarts de la voie 1 par rapport à la voie 4 en référence
• Ecarts 2.4 : calcul des écarts de la voie 2 par rapport à la voie 4 en référence
• Ecarts 3.4 : calcul des écarts de la voie 2 par rapport à la voie 4 en référence
• Ecarts 1.3 : calcul des écarts de la voie 1 par rapport à la voie 3 en référence
• Ecarts 2.3 : calcul des écarts de la voie 2 par rapport à la voie 3 en référence

les 4 cas étant obtenus de la façon suivante :
• Cas 1 (sans la voie E1) : Ecarts 2.4 et Ecarts 3.4
• Cas 2 (sans la voie E2) : Ecarts 1.4 et Ecarts 3.4
• Cas 3 (sans la voie E3) : Ecarts 1.4 et Ecarts 2.4
• Cas 4 (sans la voie E4) : Ecarts 1.3 et Ecarts 2.3

et **en ce qu'**il est configuré pour déterminer, en comparant les résultats obtenus, s'ils existent une cohérence dans tous les 4 cas, ce qui signifie que les quatre voies sont correctes et **en ce que**, s'il n'existe pas de cohérence dans ces quatre cas, on examine s'il existe une cohérence dans un seul cas, si oui cela signifiant qu'une voie est fausse, la fréquence retenue étant celle issue de ce cas, sinon, c'est à dire s'il y a cohérence dans 3 cas, 2 cas ou aucun cas, on rejette la mesure.

22. Récepteur hyperfréquences selon l'une des revendications 18 à 21, **caractérisé en ce que** d'un dans un troisième niveau de rejet au niveau d'un système comportant plusieurs récepteurs, le système fournissant en outre un niveau du signal reçu, les mesures de niveau et les fréquences fournies par les récepteurs sont regroupées et corrélées pour détecter la fréquence du signal reçu, ces mesures étant fournies à la même cadence et étant synchronisées et **en ce qu'**on effectue le rejet de toutes les fréquences si le niveau reçu est sous un seuil de détection.

23. Récepteur hyperfréquences selon la revendication 22, **caractérisé en ce que** le dispositif est configuré pour effectuer le rejet d'une fréquence si elle s'éloigne d'un nuage de points cohérents pendant une impulsion de signal reçu.

**Claims**

1. A microwave frequency receiver configured for measuring the frequency F of microwave frequency signals received by the receiver in a frequency band of which the maximum frequency is Fmax, the receiver including N frequency measurement digital steps E1, E2, ...Ek, ...EN providing N ambiguous frequency measurements Fm1, Fm2,...Fmk,...FmN of the received signal, the received signal being sampled, in each digital step, at a respective sampling frequency Fe1, Fe2,...Fek,...FeN, the receiver further comprising an ambiguity resolution device (40) receiving the N frequency measurements and providing the frequency F of the received signal, each digital frequency measurement step Ek comprising:

    - a one bit analogue-to-digital converter (50) directly fed by the microwave frequency signal received by the receiver, each converter providing a real digital signal at a sampling frequency Fek,
    - computation means for performing a discrete Fourier transform from the output samples of the one bit converter,
    - at least one detector of the line maximum (60, 62) of the discrete Fourier transform provided by the computation means,

    **characterised in that** each frequencymeter Ek (k assuming an integer between 1 and N) provides Nptk sampling points to a DFT device (52) for computing the discrete Fourier transform from the sampling points, the DFT computation device (52) performing the discrete Fourier transform on Nptk points in a continuous operation with a 50% time overlap, the device providing a first output (54) with a first discrete Fourier transform TFDi-1 of the Nptk sampling points during a first sampling time period Tei-1 and at a second output (56) a second discrete Fourier transform TFDi of the Nptk sampling points during a second sampling time period Tei overlapping with the first over 50% of the sampling time of the Nptk points (i being the time index of the discrete Fourier transform or DFT).

2. The microwave frequency receiver according to claim 1, **characterised in that** the respective sampling frequencies Fe1, Fe2,...Fek,...FeN of the one bit analogue-to-digital converters in the receiver steps are lower than the maximum frequency Fmax of the band of the receiver.

3. The microwave frequency receiver according to any one of claims 1 to 2, **characterised in that** as the frequency is the only processed information, the amplitude quantization of the received signal is performed on one bit, which is equivalent to a phase quantization in two states.

4. The microwave frequency receiver according to any one of claims 1 to 3, **characterised in that** digitisation of the signal is performed by a D-type flip-flop, the passband of which covers at least the microwave frequency band Fmax.

5. The microwave frequency receiver according to any one of claims 1 to 4, **characterised in that** it comprises:

- a wide band amplifier Amp for adapting the signal se(t) received by the antenna to the frequency measurement digital steps;
- N digital steps E1, E2,...Ek,...EN for measuring the frequency (frequencymeter) of the received signal s(t) at the amplifier Amp output, each step respectively providing, from the received signal s(t) applied at an input of the frequencymeter Efk, a measurement frequency Fmk (where k is the index of the frequency measurement channel, or the frequencymeter, taking the integer of 1 to N), each step sampling the signal s(t) applied at its input Efk at a respective sampling frequency Fe1, Fe2,...Fek,...FeN;
- a device (40) for resolving the ambiguities in the frequencies Fmk measured by the various frequency measurement digital steps E1, E2,...Ek,...EN providing a true value (Fmeasurement) of the frequency of the signal received by the receiver.

6. The microwave frequency receiver according to claim 5, **characterised in that** each frequencymeter E1, E2,...Ek,...EN provides, at a respective output Sfk, a frequency measurement Fmk expressed as:

for frequencymeter E1, $Fm1 = +/- (Fx-K1*Fe1)$

for frequencymeter Ek, $Fmk = +/- (Fx-Kk*Fek)$

for frequencymeter EN, $FmN = +/- (Fx-KN*FeN)$

7. The microwave frequency receiver according to any one of claims 1 to 6, **characterised in that** the sampling frequency Fe1, Fe2,...Fek,...FeN of each frequencymeter is markedly lower than the frequency required to comply with the Shannon theorem for sampling at the maximum frequency Fmax.

8. The microwave frequency receiver according to any one of claims 1 to 7, **characterised in that** each output (54, 56) of the DFT computation device feeds a respective peak detector (60, 62) to detect the maximum line of each discrete Fourier transform TFDi-1 and TDFi, each peak detector providing a respective gross frequency measurement FGi-1 and FGi, the resolution of which is Fek/Nptk, the measurements being emitted with a recurrence of Nptk/(2.Fek).

9. The microwave frequency receiver according to claim 8, **characterised in that** each row k frequencymeter Ek includes a device for measuring (63) the frequency Fmk receiving, on the one hand, via two inputs (64, 66) the two results from the two discrete Fourier transforms TFDi-1 and TFDi (time indices i-1 and i), for calculating a fine frequency Fi but having an ambiguity and, on the other hand, via two other inputs (68, 70), the respective gross frequency measurements FGi-1 and FGi at the output of the respective peak detectors (60, 62) to resolve the ambiguity on the fine frequency Fi and provide an output (74) of the frequency measurement device (63) the measurement frequency Fmk of the frequencymeter of row k.

10. The microwave frequency receiver according to any one of claims 7 to 9, **characterised in that** the two discrete Fourier transforms at the output of the DFT computation device (52) are based on integration supports separated by a delay τ
where

$$\tau = Nptk/(2.Fek),$$

thus presenting a phase difference φ so that:

$$\varphi = 2.\pi.F.\tau$$

this phase difference φ providing a fine frequency measurement Fi which is ambiguous and the ambiguity of which is resolved by the gross frequency measurement FGi-1 and FGi.

11. The microwave frequency receiver according to any one of claims 1 to 10, **characterised in that** the computations of channels 1, 2,...k,...N are synchronised at the same frequency as soon as the receiver is added.

12. The microwave frequency receiver according to any one of claims 1 to 10, **characterised in that** synchronisation of the computations is performed at the output of the DFT computation device (52) and that this requires compliance with the following relation:

$$\frac{Nptk}{Fek} = Cte,$$

Cte being a constant.

**13.** The microwave frequency receiver according to claim 1, **characterised in that** the DFT computation is performed at any number of sampling points including a first number, the DFT is expressed as:

$$\left[X_N(k)\right] = \sum_{n=0}^{N-1}\left[x(n).W_N^{kn}\right] \quad \text{where } W_N^{kn} = e^{-j2\pi\left(\frac{nk}{N}\right)}$$

the multiplications:

$$\left[x(n).W_N^{kn}\right]$$

being replaced by a basic logic operation.

**14.** The microwave frequency receiver according to claim 13, **characterised in that** the roots of the unit $W_N^{kn}$ which move in a united circle are replaced by the closest points among the points shown on a root square of the unit $W_N^{kn}$.

**15.** The microwave frequency receiver according to claim 1, **characterised in that** in order to resolve the ambiguities in the frequencies measured by the frequencymeters, the ambiguity resolution device (40) scans the possible frequencies F1, F2, F3,...Fp at the input of the receiver which have a difference between frequency measurement channels (Ek) below a decision threshold Sd.

**16.** The microwave frequency receiver according to claim 15, **characterised in that** the ambiguity resolution device (40) computes, for each channel Ek (or receiver Ek), all possible frequencies (F1k, F2k, F3k,...Fpk) from the frequency Fmk but is limited to the frequency range to be processed,

• then a channel Er, among all of the channels E1, E2,...Er,...Ek,...Ex,..Ey,...EN of the receiver, is taken as a reference, and for each possible frequency (F1r, F2r, F3r,...Fpr) of this reference channel Er, the ambiguity resolution device (40) performs:

- a scan on two other channels Ex, Ey of the receiver of the possible frequency (F1x, F2x, F3x,....Fpx) of the channel Ex and of the possible frequency (F1y, F2y, F3y,....Fpy) of the closest channel Ey, each of the frequencies (F1r, F2r, F3r,....Fpr) of the reference channel Er, and then the ambiguity resolution device (40) performs:
- a computation of the various differences between the frequencies closest to channels Ex, Ey in relation to the frequencies (F1r, F2r, F3r,....Fpr) of the reference channel Er,
- a test of the differences relative to the decision threshold Sd,

• if a coherence case is found, determined by differences below the threshold Sd, the ambiguity is considered resolved,
• if the differences are higher than the decision threshold, a lack of coherence is considered and this measurement is rejected.

**17.** The microwave frequency receiver according to claim 16, **characterised in that** in order to improve the standard deviation of the measurement error, the ambiguity resolution device (40) computes the average between the 3 possible frequencies which have been retained (one per channel).

18. The microwave frequency receiver according to any one of claims 15 to 17, **characterised in that** it is configured to implement frequency measurement rejection criteria.

19. The microwave frequency receiver according to claim 18, **characterised in that** each output (54, 56) of the DFT computation device feeding a respective peak detector (60, 62) to detect the maximum line of each discrete transform Fourier TFDi-1 and TDFi, each peak detector providing a respective gross frequency measurement FGi-1 and FGi the resolution of which is Fek/Nptk, the measurements being emitted with a sequence of Nptk/(2.Fek), the coherence between the two gross consecutive frequencies FGi-1 and FGi of the frequencymeters is examined, if the difference is higher than a line, the difference of a line corresponding to the spectral resolution at the output of the DFT, the measurement is rejected.

20. The microwave frequency receiver according to one of claims 18 or 19, **characterised in that** in a second measurement rejection level, the receiver comprising four frequency measurement channels E1, E2, E3 and E4 (N=4), a rejection algorithm takes into account the fact that a measurement channel may be false and **in that** the coherence between the channels is tested in the following four examples.

   - case 1: by removing channel E1 and using channels E2, E3 and E4,
   - case 2: by removing channel E2 and using channels E1, E3 and E4,
   - case 3: by removing channel E3 and using channels E1, E2 and E4,
   - case 4: by removing channel E4 and using channels E1, E2 and E3,

   in each of the aforementioned cases, the reference channel used to compute the differences is any one of the 3 channels used, but cannot be the deleted channel.

21. The microwave frequency receiver according to claim 20, **characterised in that** it is configured to explore the four examples, by calculating the differences in the following 5 configurations:

   • Differences 1.4: compute differences in channel 1 relative to channel 4 as reference
   • Differences 2.4: compute differences in channel 2 relative to channel 4 as reference
   • Differences 3.4: compute differences in channel 2 relative to channel 4 as reference
   • Differences 1.3: compute differences in channel 1 relative to channel 3 as reference
   • Differences 2.3: compute differences in channel 2 relative to channel 3 as reference
   the 4 cases being obtained as follows:
   • Case 1 (without channel E1): Differences 2.4 and Differences 3.4
   • Case 2 (without channel E2): Differences 1.4 and Differences 3.4
   • Case 3 (without channel E3): Differences 1.4 and Differences 2.4
   • Case 4 (without channel E4): Differences 1.3 and Differences 2.3

   and **in that** it is configured to determine, by comparing the results obtained, whether coherence exists in all 4 cases, which signifies that the four channels are correct and **in that**, if coherence does not exist in these four cases, the existence of coherence in a single case is examined, if coherence is found this signifies that one channel is false, the frequency retained being that which originates from this case, otherwise, that is, if there is coherence in 3 cases, 2 cases or no cases, the measurement is rejected.

22. The microwave frequency receiver according to any one of claims 18 to 21, **characterised in that** in a third rejection level in a system comprising several receivers, the system further providing a received signal level, the level measurements and the frequencies provided by the receivers are rearranged and correlated to detect the received signal frequency, these measurements being provided at the same rate and being synchronised and **in that** all of the frequencies are rejected if the received level is below a detection threshold.

23. The microwave frequency receiver according to claim 22, **characterised in that** the device is configured to reject a frequency if it deviates from a cluster of coherent points during a received signal pulse.


**Patentansprüche**

1. Ultrahochfrequenzempfänger zum Messen der Frequenz F des von dem Empfänger empfangenen Ultrahochfrequenzsignals in einem Frequenzband, dessen maximale Frequenz Fmax ist, wobei der Empfänger N digitale Frequenzmessstufen E1, E2, ... Ek, ... EN umfasst, die N uneindeutige Frequenzmessungen Fm1, Fm2, ... Fmk, ... FmN des empfangenen Signals liefern, wobei das empfangene Signal in jeder digitalen Stufe auf einer jeweiligen Abtastfrequenz Fe1, Fe2, ... Fek, ... FeN abgetastet wird, wobei der Empfänger darüber hinaus eine Ambiguitätsauflösungsvorrichtung (40) umfasst, die die N Frequenzmesswerte empfängt und die Frequenz F des empfangenen Signals liefert, wobei jede digitale Frequenzmessstufe Ek Folgendes umfasst:

- einen Ein-Bit-Analog-Digital-Wandler (50), der von dem von dem Empfänger empfangenen Ultrahochfrequenzsignal direkt gespeist wird, wobei jeder Wandler ein reelles digitales Signal auf einer Abtastfrequenz Fek liefert,
- Rechenmittel zum Bewirken einer diskreten Fourier-Transformation von Abtastungen am Ausgang des Ein-Bit-Wandlers,
- wenigstens einen Maximalliniendetektor (60, 62) der von dem Rechenmittel gelieferten diskreten Fourier-Transformation,

**dadurch gekennzeichnet, dass** jeder Frequenzmesser Ek (wobei k eine ganze Zahl zwischen 1 und N annimmt) Nptk Abtastpunkte zu einem DFT-Gerät (52) zum Berechnen der diskreten Fourier-Transformation von den Abtastpunkten liefert, wobei das DFT-Rechengerät (52) die diskrete Fourier-Transformation an Nptk Punkten fortlaufend mit einer zeitlichen Überlappung von 50 % liefert, wobei das Gerät eine erste diskrete Fourier-Transformation TFDi-1 von Nptk Abtastpunkten während einer ersten Abtastzeitperiode Tei-1 zu einem ersten Ausgang (54) und eine zweite diskrete Fourier-Transformation TFDi von Nptk Abtastpunkten während einer zweiten Abtastzeitperiode Tei zu einem zweiten Ausgang (56) liefert, die mit der ersten um 50 % der Abtastzeit der Nptk Punkte überlappt (wobei i der Zeitindex der diskreten Fourier-Transformationen oder DFT ist).

2. Ultrahochfrequenzempfänger nach Anspruch 1, **dadurch gekennzeichnet, dass** die jeweiligen Abtastfrequenzen Fe1, Fe2, ... Fek, ... FeN der Ein-Bit-Analog-Digital-Wandler der Stufen des Empfängers kleiner als die Höchstfrequenz Fmax des Bandes des Empfängers sind.

3. Ultrahochfrequenzempfänger nach Anspruch 1 oder 2, **dadurch gekennzeichnet, dass** die Frequenz die einzige bearbeitete Information ist, die Amplitudenquantifizierung des empfangenen Signals an einem einzigen Bit erfolgt, was mit einer Phasenquantisierung in zwei Zuständen äquivalent ist.

4. Ultrahochfrequenzempfänger nach einem der Ansprüche 1 bis 3, **dadurch gekennzeichnet, dass** die Digitalisierung des Signals durch einen D-Flipflop erfolgt, dessen Passband wenigstens das Ultrahochfrequenzband Fmax abdeckt.

5. Ultrahochfrequenzempfänger nach einem der Ansprüche 1 bis 4, **dadurch gekennzeichnet, dass** er Folgendes umfasst:

- einen Breitbandverstärker Amp zum Adaptieren des von der Antenne empfangenen Signals se(t) an digitale Frequenzmessstufen;
- N digitale Stufen E1, E2, ... Ek, ... EN zum Messen der Frequenz (oder Frequenzmesser) des empfangenen Signals s(t) am Ausgang des Verstärkers Amp, wobei jede Stufe jeweils auf der Basis des an einem Eingang Efk des Frequenzmessers anliegenden empfangenen Signals s(t) eine Messfrequenz Fmk liefert (wobei k den Frequenzmesskanal oder den Frequenzmesser anzeigt, der ganze Zahlen von 1 bis N annimmt), wobei jede Stufe das an seinem Eingang Efk anliegende Signal s(t) bei einer jeweiligen Abtastfrequenz Fe1, Fe2, ... Fek, ... FeN abtastet;
- ein Gerät (40) zum Auflösen der Ambiguitäten an den gemessenen Frequenzen Fmk durch die verschiedenen digitalen Frequenzmessstufen E1, E2, ... Ek, ... EN, die einen wahren Wert (Fmesure) der Frequenz des von dem Empfänger empfangenen Signals liefert.

6. Ultrahochfrequenzempfänger nach Anspruch 5, **dadurch gekennzeichnet, dass** jeder Frequenzmesser E1, E2, ... Ek, ... EN an einem jeweiligen Ausgang Sfk ein Maß für die Frequenz Fmk liefert, ausgedrückt durch:

für Frequenzmesser E1, $Fm1 = +/- (Fx - K1*Fe1)$

für Frequenzmesser Ek, $Fmk = +/- (Fx - Kk*Fek)$

für Frequenzmesser EN, $FmN = +/- (Fx - KN*FeN)$

7. Ultrahochfrequenzempfänger nach einem der Ansprüche 1 bis 6, **dadurch gekennzeichnet, dass** die Abtastfrequenz Fe1, Fe2, ... Fek, ... FeN jedes Frequenzmessers deutlich kleiner ist als die, die in Bezug auf das Shannon-Theorem für das Abtasten mit der maximalen Frequenz Fmax nötig ist.

8. Ultrahochfrequenzempfänger nach einem der Ansprüche 1 bis 7, **dadurch gekennzeichnet, dass** jeder Ausgang (54, 56) des DFT-Rechengerätes einen jeweiligen Spitzendetektor (60, 62) speist, um die Maximallinie jeder diskreten Fourier-Transformation TFDi-1 und TDFi zu detektieren, wobei jeder Spitzendetektor jeweils ein Grobfrequenzmaß FGi-1 und FGi liefert, dessen Auflösung Fek/Nptk ist, wobei die Messwerte mit einer Rekurrenz von Nptk/(2. Fek) ausgegeben werden.

9. Ultrahochfrequenzempfänger nach Anspruch 8, **dadurch gekennzeichnet, dass** jeder Frequenzmesser Ek in Reihe k ein Gerät (63) zum Messen der Frequenz Fmk umfasst, das einerseits über zwei Eingänge (64, 66) die beiden Ergebnisse der beiden diskreten Fourier-Transformationen TFDi-1 und TFDi (Zeitindexe i-1 und i) zum Berechnen einer fein genannten Frequenz Fi, aber mit einer Ambiguität, und andererseits über zwei andere Eingänge (68, 70) empfangen, deren jeweilige Grobfrequenzmesswerte FGi-1 und FGi am Ausgang der jeweiligen Spitzendetektoren (60, 62) zum Auflösen der Ambiguität an der feinen Frequenz Fi umfassen und an einem Ausgang (74) des Frequenzmessgeräts (63) das Frequenzmaß Fmk des Frequenzmessers von Reihe k ausgeben.

10. Ultrahochfrequenzempfänger nach einem der Ansprüche 7 bis 9, **dadurch gekennzeichnet, dass** die beiden diskreten Fourier-Transformationen am Ausgang des DFT-Rechengerätes (52) auf den Integrationsunterstützungen getrennt durch eine Verzögerung τ stützen,
wobei

$$\tau = \text{Nptk}/(2.\ \text{Fek}),$$

und dabei eine solche Phasendifferenz φ aufweisen, dass

$$\varphi = 2\ \pi.F.\tau$$

wobei diese Phasendifferenz φ ein feines Frequenzmaß Fi liefert, das uneindeutig ist und dessen Ambiguität durch den Grobfrequenzmesswert FGi-1 und FGi aufgelöst wird.

11. Ultrahochfrequenzempfänger nach einem der Ansprüche 1 bis 10, **dadurch gekennzeichnet, dass** die Berechnungen der Kanäle 1, 2, ... k, ... N auf derselben Frequenz synchronisiert werden, sobald der Empfänger zugeschaltet wird.

12. Ultrahochfrequenzempfänger nach einem der Ansprüche 1 bis 10, **dadurch gekennzeichnet, dass** die Synchronisation der Berechnungen am Ausgang des DFT-Rechengeräts (52) erfolgt, wobei dazu die folgende Beziehung zu respektieren ist:

$$\frac{Nptk}{Fek} = Cte,$$

wobei Cte eine Konstante ist.

13. Ultrahochfrequenzempfänger nach Anspruch 1, **dadurch gekennzeichnet, dass** die DFT-Berechnung an einer beliebigen Anzahl von Abtastpunkten einschließlich einer ersten Zahl erfolgt, wobei die DFT wie folgt ausgedrückt wird:

$$[X_N(k)] = \sum_{n=0}^{N-1} [x(n).W_N^{kn}] \quad \text{wobei}\ .W_N^{kn} = e^{-j2\pi\left(\frac{nk}{N}\right)}$$

wobei die Multiplikationen:

$$\left[ x(n).W_N^{kn} \right]$$

durch eine elementare Logikoperation ersetzt werden.

14. Ultrahochfrequenzempfänger nach Anspruch 13, **dadurch gekennzeichnet, dass** die Wurzeln der Einheit $W_N^{km}$, die über einem vereinten Kreis verschoben ist, durch die nächstliegenden Punkte unter den auf einem Wurzelquadrat der Einheit $W_N^{km}$ angezeigten Punkten ersetzt wird.

15. Ultrahochfrequenzempfänger nach Anspruch 1, **dadurch gekennzeichnet, dass** zum Auflösen der Ambiguitäten an den von den Frequenzmessern gemessenen Frequenzen das Ambiguitätsauflösungsgerät (40) die möglichen Frequenzen F1, F2, F3, ... Fp am Eingang des Empfängers sucht, die eine Differenz zwischen Frequenzmesskanälen (Ek) haben, die kleiner ist als ein Entscheidungsschwellenwert Sd.

16. Ultrahochfrequenzempfänger nach Anspruch 15, **dadurch gekennzeichnet, dass** das Ambiguitätsauflösungsgerät (40) für jeden Kanal Ek (oder Empfänger Ek) alle möglichen Frequenzen (F1k, F2k, F3k, ... Fpk) anhand der Frequenz Fmk berechnet, wobei es sich auf den zu bearbeitenden Frequenzbereich begrenzt,

   • wobei dann ein Kanal Er aus allen Kanälen E1, E2, ... Er, ... Ek, ... Ex, ...Ey, ... EN des Empfängers als Referenz genommen wird und das Ambiguitätsauflösungsgerät (40) für jede mögliche Frequenz (F1r, F2r, F3, ... Fpr) dieses Referenzkanals Er Folgendes durchführt:

   - eine Suche auf zwei anderen Kanälen Ex, Ey des Empfängers nach der möglichen Frequenz (F1x, F2x, F3x, ... Fpx) des Kanals Ex und nach der möglichen Frequenz (F1y, F2y, F3y, ... Fpy) des nächstliegenden Kanals Ey jeder der Frequenzen (F1r, F2r, F3r, ... Fpr) des Referenzkanals Er, danach führt das Ambiguitätsauflösungsgerät (40) Folgendes aus:
   - eine Berechnung der verschiedenen Differenzen zwischen den den Kanälen Ex, Ey am nächsten liegenden Frequenzen in Bezug auf die Frequenzen (F1r, F2r, F3r, ... Fpr) des Referenzkanals Er,
   - einen Test der Differenzen in Bezug auf den Entscheidungsschwellenwert Sd,

   • wenn ein Fall von Kohärenz gefunden wird, ermittelt anhand von Differenzen, die kleiner als der Schwellenwert Sd sind, dann wird die Ambiguität als aufgelöst angesehen,
   • wenn die Differenzen größer als der Entscheidungsschwellenwert sind, dann wird festgestellt, dass es keine Kohärenz gibt, und dieser Messwert wird zurückgewiesen.

17. Ultrahochfrequenzempfänger nach Anspruch 16, **dadurch gekennzeichnet, dass** das Ambiguitätsauflösungsgerät (40) zum Verbessern der Standardabweichung des Messfehlers den Durchschnitt zwischen den 3 behaltenen möglichen Frequenzen berechnet (eine pro Kanal).

18. Ultrahochfrequenzempfänger nach den Ansprüchen 15 bis 17, **dadurch gekennzeichnet, dass** er so konfiguriert ist, dass er die Kriterien für die Rückweisung von Frequenzmesswerten umsetzt.

19. Ultrahochfrequenzempfänger nach Anspruch 18, **dadurch gekennzeichnet, dass** jeder Ausgang (54, 56) des DFT-Rechengerätes einen jeweiligen Spitzendetektor (60, 62) zum Detektieren der Maximallinie jeder der diskreten Fourier-Transformationen TFDi-1 und TDFi speist, jeder Spitzendetektor einen jeweiligen Grobfrequenzmesswert FGi-1 und FGi liefert, dessen Auflösung Fek/Nptk ist, die Messwerte mit einer Rekurrenz von Nptk/(2. Fek) ausgegeben werden, die Kohärenz zwischen den beiden konsekutiven Grobfrequenzen FGi-1 und FGi der Frequenzmesser untersucht wird, und der Messwert, wenn die Differenz über einer Linie liegt, wobei die Differenz einer Linie der Spektralauflösung am Ausgang der DFT entspricht, zurückgewiesen wird.

20. Ultrahochfrequenzempfänger nach einem der Ansprüche 18 oder 19, **dadurch gekennzeichnet, dass** in einer zweiten Messwertrückweisungsebene der Empfänger, der vier Frequenzmesskanäle E1, E2, E3 und E4 (N=4) aufweist, ein Rückweisungsalgorithmus die Tatsache berücksichtigt, dass ein Messkanal falsch sein kann, und **dadurch**, dass die Kohärenz zwischen den Kanälen in den folgenden vier Beispielen getestet wird:

   - Fall 1: durch Entfernen von Kanal E1 und Verwenden der Kanäle E2, E3 und E4,

- Fall 2: durch Entfernen von Kanal E2 und Verwenden der Kanäle E1, E3 und E4,
- Fall 3: durch Entfernen von Kanal E3 und Verwenden der Kanäle E1, E2 und E4,
- Fall 4: durch Entfernen von Kanal E4 und Verwenden der Kanäle E1, E2 und E3,

wobei in jedem der obigen Fälle der zum Berechnen der Differenzen verwendete Referenzkanal ein beliebiger von 3 angewendeten Kanälen ist, aber nicht der entfernte Kanal sein kann.

21. Ultrahochfrequenzempfänger nach Anspruch 20, **dadurch gekennzeichnet, dass** er zum Untersuchen der vier Beispielfälle durch Berechnen der Differenzen in den folgenden 5 Konfigurationen konfiguriert ist:

   • Differenzen 1.4: Berechnen der Differenzen von Kanal 1 in Bezug auf Kanal 4 als Referenz
   • Differenzen 2.4: Berechnen der Differenzen von Kanal 2 in Bezug auf Kanal 4 als Referenz
   • Differenzen 3.4: Berechnen der Differenzen von Kanal 2 in Bezug auf Kanal 4 als Referenz
   • Differenzen 1.3: Berechnen der Differenzen von Kanal 1 in Bezug auf Kanal 3 als Referenz
   • Differenzen 2.3: Berechnen der Differenzen von Kanal 2 in Bezug auf Kanal 3 als Referenz
   wobei die 4 Fälle auf die folgende Weise erhalten werden:
   • Fall 1 (ohne Kanal E1): Differenzen 2.4 und Differenzen 3.4
   • Fall 2 (ohne Kanal E2): Differenzen 1.4 und Differenzen 3.4
   • Fall 3 (ohne Kanal E3): Differenzen 1.4 und Differenzen 2.4
   • Fall 4 (ohne Kanal E4): Differenzen 1.3 und Differenzen 2.3

   und **dadurch**, dass er konfiguriert ist zu ermitteln, durch Vergleichen der erhaltenen Ergebnisse, ob Kohärenz in allen 4 Fällen vorliegt, was bedeutet, dass die vier Kanäle korrekt sind, und **dadurch**, dass, wenn keine Kohärenz in diesen vier Fällen besteht, untersucht wird, ob Kohärenz in einem einzigen Fall vorliegt, und wenn ja, dann bedeutet dies, dass ein Kanal falsch ist, wobei die behaltene Frequenz die von diesem Fall stammende ist, andernfalls, das heißt, wenn es Kohärenz in 3 Fällen, 2 Fällen oder in keinem Fall gibt, wird der Messwert zurückgewiesen.

22. Ultrahochfrequenzempfänger nach einem der Ansprüche 18 bis 21, **dadurch gekennzeichnet, dass** das System in einer dritten Rückweisungsebene bei einem System mit mehreren Empfängern darüber hinaus einen Pegel des empfangenen Signals liefert, wobei die von den Empfängern gelieferten Pegelmesswerte und Frequenzen umgruppiert und korreliert werden, um die Frequenz des empfangenen Signals zu detektieren, wobei diese Messwerte im selben Takt und synchronisiert geliefert werden, und **dadurch**, dass die Rückweisung aller Frequenzen erfolgt, wenn der empfangene Pegel unter einem Detektionsschwellenwert liegt.

23. Ultrahochfrequenzempfänger nach Anspruch 22, **dadurch gekennzeichnet, dass** das Gerät so konfiguriert ist, dass es eine Frequenz zurückweist, wenn sie sich während eines empfangenen Signalimpulses von einem Cluster von kohärenten Punkten entfernt.

FIG.1

FIG.2

EP 1 982 209 B1

F mesure

Fe/2

Fmk

FIG.3

F1    F2    F3

Fentrée

Fe1 << 2* Fmax

E1

40

S(t)

Ef1

Fréquencemètre 1
Fm1 = +/- (Fx – K1*Fe1)

Fm1

Se (t)

Amp

Fx
<Fmax

Sf1

Fek << 2* Fmax

Ek

Efk

Fréquencemètre k
Fmk = +/- (Fx – Kk*Fek)

Fmk

Dispositif de
Levée d'ambiguïté

Fmesure

Sfk

FeN << 2* Fmax

EN

EfN

Fréquencemètre N
FmN = +/- (Fx – KN*FeN)

FmN

FIG.4

SfN

**FIG.5**

**FIG.6**

**FIG.7**

**EP 1 982 209 B1**

## RÉFÉRENCES CITÉES DANS LA DESCRIPTION

**Documents brevets cités dans la description**

- FR 2695730